# EUROPEAN PATENT APPLICATION

(11) **EP 4 845 341 A1**
(43) Date of publication of application: **25.11.2026**
(21) Application number: 26174981.6
(22) Date of filing: 28.04.2026
(51) Int. Cl.: H10D 62/10, H10D 8/60

(54) **MULTIDRAIN SIC-BASED DEVICE AND MANUFACTURING METHOD THEREFOF**

(30) Priority: 23.05.2025 IT 202500011779
(71) Applicant: STMicroelectronics International N.V., 1228 Plan-les-Ouates, Geneva (CH)
(72) Inventor: ZANETTI, Edoardo, 20864 AGRATE BRIANZA (MB) (IT); BELLOCCHI, Gabriele, 20864 AGRATE BRIANZA (MB) (IT); ZUMBO, Luca, 20864 AGRATE BRIANZA (MB) (IT); RASCUNA', Simone, 20864 AGRATE BRIANZA (MB) (IT); GUARNERA, Alfio, 20864 AGRATE BRIANZA (MB) (IT); SAGGIO, Mario Giuseppe, 20864 AGRATE BRIANZA (MB) (IT)
(74) Representative: Studio Torta S.p.A.

(57) **Abstract**

Electronic device (1), comprising: a substrate (3) of silicon carbide, SiC; a structural layer (2) of N-type SiC, on the substrate (3); and at least one active region (9') in the structural layer (2), configured to generate and/or conduct electric current during use of the electronic device (1). The active region (9') is a P-type doped region and extends in depth in the structural layer (2) for an extension greater than half the thickness of the structural layer (2).

## Description

### Technical Field of the Invention

The present invention relates to a SiC electronic device and a method of manufacturing a SiC electronic device. In particular, the present invention relates to an electronic device for high power applications.

### State of the Art

Multidrain Silicon Carbide (MD-SiC) technology is a type of technology known to the Applicant that uses silicon carbide as a semiconductor material. Silicon carbide has several advantages compared to traditional silicon-based semiconductors, including higher thermal conductivity, higher breakdown voltage, and higher electron mobility. A device made by using MD-SiC technology has a plurality of parallel drain wells that allow better current handling capability and lower on-state resistance (R_{ON}) than single-drain power devices. This technology is particularly useful in high-power applications such as that used in electric vehicles, renewable energy systems, and drivers for industrial motors where high efficiency and reliability are critical. Devices made by using MD-SiC technology also have high conductivity at high temperatures, making them suitable for harsh environments.

The technology described above is applicable to a variety of device types, including for example MOSFETs, MPS (Merged-PN-Schottky) diodes, Schottky diodes, JBS (Junction Barrier Schottky) diodes, IGBTs, JFETs, DMOS, etc.

One of the problems that MD-SiC devices solve relates to the high-power losses in traditional silicon-carbide-based diodes. When a diode is turned on, it has some resistance to the current flow. This resistance causes energy to be dissipated in the form of heat, which may lead to efficiency losses and reliability issues. MD-SiC devices have a lower resistance R_{ON} than traditional SiC-based devices, which reduces power losses and improves efficiency.

Another technical problem that MD-SiC devices address relates to the reduction of the reverse recovery time. When a traditional diode is turned off, it takes some time for current to stop flowing therethrough. This time is known as the reverse recovery time and may cause voltage peaks and other issues in high-power applications.

As a whole, MD-SiC devices represent a significant advance in power electronics technology, solving several technical issues and allowing more efficient and reliable power conversion.

There is therefore a need to develop MD-SiC device technology, proposing new products and new methods of manufacturing the same.

The objective of the present invention is to provide a method of manufacturing a SiC electronic device, and a SiC electronic device.

### Object and Summary of the Invention

According to the present invention, an electronic device and a method of manufacturing an electronic device are provided, as defined in the appended claims.

### Brief Description of the Drawings

For a better understanding of the present invention, its preferred embodiments are now described, purely by way of non-limiting example, in reference to the attached drawings, wherein:
- Figure 1 shows, in cross-sectional view, an electronic device, in particular an MPS diode, according to one embodiment of the present invention;
- Figure 2 graphically illustrates the variation of doping concentration along a vertical direction referred to an electrically active region of the electronic device of Figure 1;
- Figures 3A-3C, 4A-4C, 5A-5D and 6A-6D, show respective manufacturing steps of a portion of the electronic device of Figure 1, according to respective embodiments of the present invention; and
- Figures 3D, 4D, 5E, 6E show respective additional manufacturing steps with respect to those of Figures 3C, 4C, 5D, 6D, for manufacturing a portion of a MOSFET according to respective embodiments of the present invention.

### Preferred Embodiments of the Invention

The present invention will be described in part with specific reference to a merged-PN-Schottky (MPS) device; however, as will be evident from the following description, the present invention applies in general to any SiC-based electronic device, in particular to a transistor such as, for example, a MOSFET.

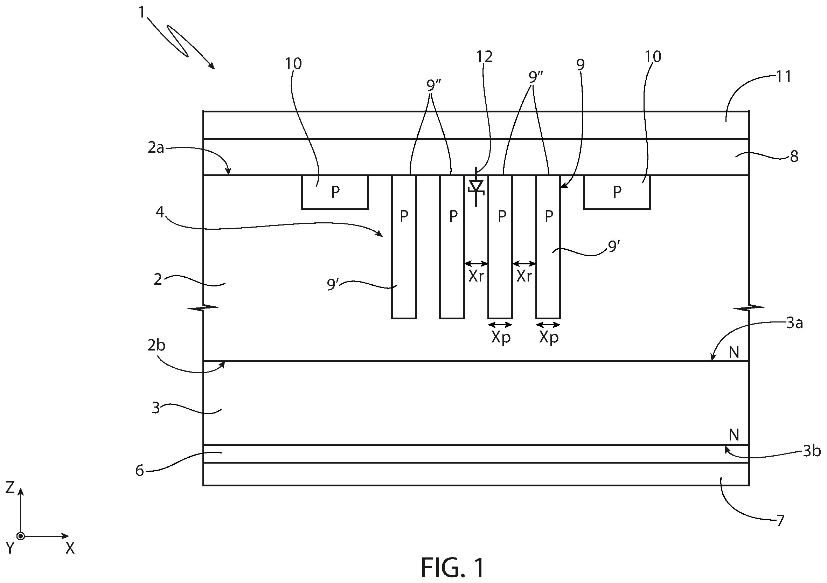

Figure 1 shows, in a lateral sectional view in a Cartesian (triaxial) reference system of axes X, Y, Z, a merged-PN-Schottky (MPS) device 1 according to an aspect of the present invention.

The MPS device 1 includes: a substrate 3, of N-type SiC, having a first dopant concentration, provided with a surface 3a opposite to a surface 3b, and a thickness comprised between 70 µm and 180 µm, for example equal to 110 µm; a drift layer (grown in an epitaxial manner) 2, of N-type SiC, having a second dopant concentration lower than the first dopant concentration that extends on the surface 3a of the substrate 3, and thickness comprised between 5 and 50 µm; an ohmic contact region, or layer 6 (e.g., with the formation of TiₓC_{y}, TiₓSi_{y} and TiₓSi_{y}C_{z} type compounds or nickel-based compounds), that extends on the surface 3b of the substrate 3; a cathode metallization 7, e.g. of Ti/NiV/Ag or Ti/NiV/Au, that extends on the ohmic contact region 6; an anode metallization 8, e.g. of Ti/AlSiCu, Ni/AlSiCu, W/AlSiCu or Mo/AlSiCu, that extends on an upper surface 2a of the drift layer 2; a passivation layer 11 on the anode metallization 8, to protect the latter; multiple junction-barrier (JB) elements 9 in the drift layer 2, facing the upper surface 2a of the drift layer 2 and each including a respective implanted region 9' of P-type and an ohmic contact 9" of metal material; and an edge termination region, or protection ring, 10 (optional), in particular a P-type implanted region, that completely surrounds the JB elements 9.

One or more Schottky diodes 12 are formed at the interface between the drift layer 2 and the anode metallization 8, laterally to the implanted regions 9'. In particular, (semiconductor-metal) Schottky junctions are formed by portions of the drift layer 2 in direct electrical contact with respective portions of the anode metallization 8.

The region of the MPS device 1 that includes the JB elements 9 and the Schottky diodes 12 (i.e., the region contained within the protection ring 10) is an active area 4 of the MPS device 1.

According to one aspect of the present invention, the implanted regions 9' extend within the drift layer 2 along a respective direction parallel to the Z-axis that is equal to or greater than half the thickness of the drift layer 2, in particular equal to or greater than 75% or 80% or 90% of the thickness of the drift layer 2.

For example, the implanted regions 9' extend within the drift layer 2 along a respective direction parallel to the Z-axis comprised between 2 and 50 µm starting from the surface 2a, as a function of the voltage class of the MPS device 1.

In one embodiment, the implanted regions 9' end within the drift layer 2, before reaching the surface 2b (similarly, the surface 3a). In a further embodiment, the implanted regions 9' reach the surface 2b (similarly, the surface 3a) and terminate at the surface 2b (similarly, the surface 3a), i.e. at the interface between the drift layer 2 and the underlying substrate 3. In a further embodiment, the implanted regions 9' extend for the entire thickness, along the Z-axis, of the drift layer 2 and penetrate in part within the substrate 3, terminating within the substrate 3 without reaching the surface 3b.

In one embodiment, each implanted region 9' has a respective uniform or substantially uniform doping profile along the Z-axis. By "substantially uniform" it is intended that the doping of the respective implanted region 9', in terms of atoms/cm³, has a same order of magnitude along the entire extension of the implanted region 9'. For example, given an order of magnitude of 10^{x}, the doping of the respective implanted region 9' varies between 1·10^{x} and 9·10^{x} at/cm³. The value of x is for example comprised between 15 and 18 (boundaries included), so that the doping of the respective implanted region 9' may vary between 1·10¹⁵ and 9·10¹⁸ at/cm³. In one embodiment, the doping density is the same for all implanted regions 9'.

In a further embodiment, each implanted region 9' has a respective doping profile variable along the Z-axis. For example, the doping density in each respective implanted region 9' may vary within 2 or more orders of magnitude. For example, given an order of magnitude of 10^{x}, the doping of the respective implanted region 9' varies between 1·10^{x-1} and 9·10^{x+1} at/cm³. The value of x is for example comprised between 15 and 18 (boundaries included), more in particular between 16 and 17 or for example equal to 16. In one embodiment, the doping density (variable in the above-mentioned range within a same region 9') is the same for all implanted regions 9'.

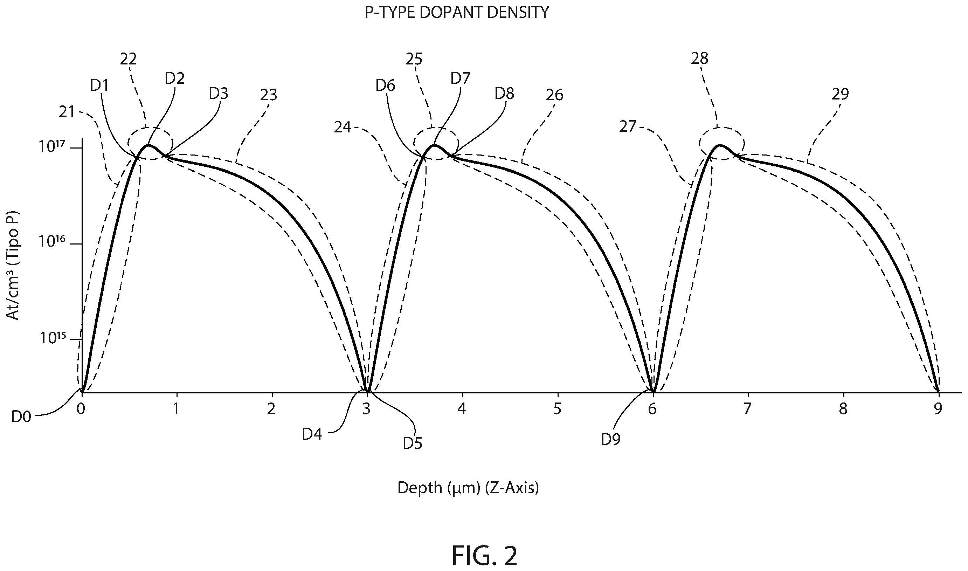

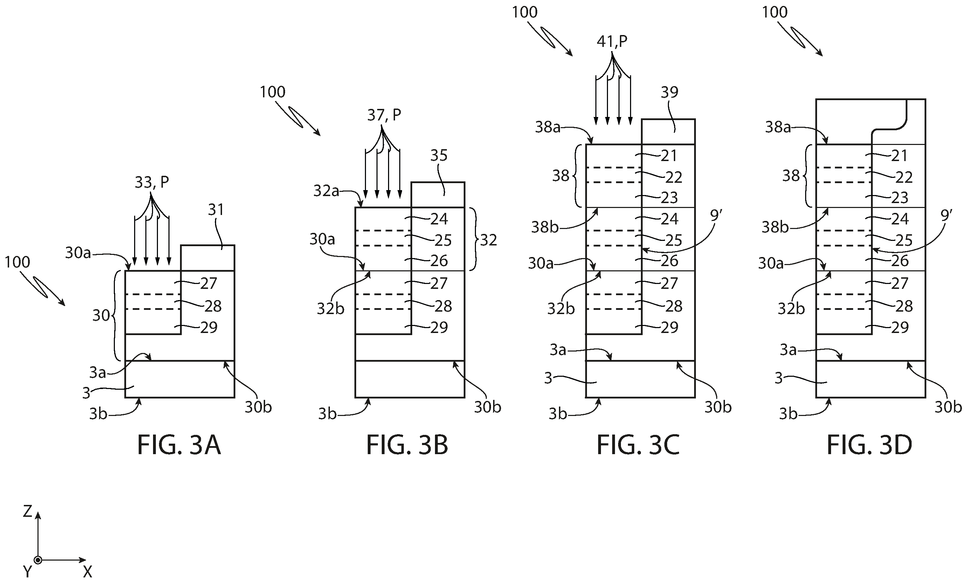

In a further embodiment, as exemplarily illustrated in Figures 2 and 3C, in each implanted region 9', a first doped sub-region 21 extends in proximity to the surface 2a of the drift layer. Then, proceeding along the Z-axis within the drift layer 2 and towards the surface 2b, a second doped sub-region 22 extends successively to, and as a continuation of, the first doped sub-region 21. Then, proceeding along the Z-axis within the drift layer 2 and towards the surface 2b, a third doped sub-region 23 extends successively to, and as a continuation of, the second doped sub-region 22.

Then, proceeding along the Z-axis within the drift layer 2 and towards the surface 2b, a fourth doped sub-region 24 extends successively to, and as a continuation of, the third doped sub-region 23. Then, proceeding along the Z-axis within the drift layer 2 and towards the surface 2b, a fifth doped sub-region 25 extends successively to, and as a continuation of, the fourth doped sub-region 24. Then, proceeding along the Z-axis within the drift layer 2 and towards the surface 2b, a sixth doped sub-region 26 extends successively to, and as a continuation of, the fifth doped sub-region 25.

Further doped sub-regions 27-29, illustrated in Figure 2 and Figures 3A-3C, may be present and are similar to the regions 21-23 and/or 24-26.

The doping profile (doping density measured as atoms/cm³) of the first doped sub-region 21 increases from a minimum value D0 to a maximum value D1 along the Z-axis direction, proceeding in depth in the drift layer 2 from the surface 2a towards the surface 2b. The doping profile of the first doped sub-region 21 is, in particular, monotonically increasing along the previously indicated direction.

The doping profile (doping density measured as atoms/cm³) of the second doped sub-region 22 is substantially uniform at a value D2 greater than D1, or alternatively has variable (non-uniform) values greater than D1.

The doping profile (doping density measured as atoms/cm³) of the third doped sub-region 23 decreases from a maximum value D3 to a minimum value D4 along the Z-axis direction, proceeding in depth in the drift layer 2 from the second doped sub-region 22 towards the surface 2b. The doping profile of the third doped sub-region 23 is, in particular, monotonically decreasing along the previously indicated direction.

The doping profile (doping density measured as atoms/cm³) of the fourth doped sub-region 24 increases from a minimum value D5 to a maximum value D6 along the Z-axis direction, proceeding in depth in the drift layer 2 from the third doped sub-region towards the surface 2b. The doping profile of the fourth doped sub-region 24 is, in particular, monotonically increasing along the previously indicated direction.

The doping profile (doping density measured as atoms/cm³) of the fifth doped sub-region 25 is substantially uniform and equal to a value D7 greater than D6, or alternatively has variable (non-uniform) values greater than D6.

The doping profile (doping density measured as atoms/cm³) of the sixth doped sub-region 26 decreases from a maximum value D8 to a minimum value D9 along the Z-axis direction, proceeding in depth in the drift layer 2 from the fifth doped sub-region 25 towards the surface 2b. The doping profile of the sixth doped sub-region 26 is, in particular, monotonically decreasing along the previously indicated direction.

In the case of the presence of further buried doped sub-regions (the sub-regions 27-29 illustrated in Figure 2), these follow (in the same succession) the doping profile already described for the sub-regions 21-23 and/or 24-26.

Figure 2 illustrates an example of trend of the doping density of the doped regions 21-29, according to what has been described.

In one embodiment, the doping density values D0-D9 are the following:
the value of D0 is comprised between 1·10¹³ and 1·10¹⁸ at/cm³;
the value of D1 is comprised between 1·10¹⁷ and 1·10¹⁹ at/cm³;
the value of D2 is comprised between 2·10¹⁷ and 1·10²⁰ at/cm³;
the value of D3 is comprised between 1·10¹⁷ and 1·10¹⁹ at/cm³;
the value of D4 is comprised between 1·10¹³ and 1·10¹⁸ at/cm³;
the value of D5 is comprised between 1·10¹³ and 1·10¹⁸ at/cm³;
the value of D6 is comprised between 1·10¹⁷ and 1·10¹⁹ at/cm³;
the value of D7 is comprised between 2·10¹⁷ and 1·10²⁰ at/cm³;
the value of D8 is comprised between 1·10¹⁷ and 1·10¹⁹ at/cm³; and
the value of D9 is comprised between 1·10¹³ and 1·10¹⁸ at/cm³.

In the case of the presence of further buried doped sub-regions (the sub-regions 27-29 illustrated in Figure 2), these follow the doping density values indicated hereinabove for the sub-regions 21-23 and/or 24-26 (according to the same succession).

Regardless of the type of doping profile of the implanted regions 9' and of the doping value of the same, each implanted region 9' has a respective lateral dimension Xp, along the X-axis (orthogonal to the Z-axis), substantially uniform along the entire vertical extension (along the Z-axis) of the respective implanted region 9', for example comprised between 1 and 5 µm, in particular equal to 2 µm. In this context, the terminology "substantially uniform" referred to the dimension Xp means that, along the vertical extension of the implanted region 9', the value of the dimension Xp may vary positively and negatively by a percentage equal to 20% of Xp. For example, given a design dimension Xp=20%, the extension along the X-axis of the respective implanted region 9' may vary between Xp-20% and Xp+20%.

Implanted regions 9' directly facing each other are separated by a respective portion of the drift layer 2 having dimension Xn, along the X-axis, comprised between 1 and 5 µm, for example equal to 2. It is evident that the value of Xn may vary along the vertical extension (along the Z-axis) of the implanted regions 9', as a function of the corresponding variation of Xp.

In top view, on the XY plane, the implanted regions 9' have an extension Yp, along the Y-axis, such that Yp>Xp. For example, Yp is in the range 100-10000 µm.

The implanted regions 9' visible in the cross-sectional view are, in a non-limiting embodiment of the present invention, fully connected to each other (i.e., they form a grid). Accordingly, the ohmic contacts 9" are also fully connected to each other, and are electrically connected to the implanted regions 9'.

An ohmic contact 9 is also formed at the protection ring 10 (if present), and is electrically connected to the ohmic contacts 9".

The formation steps of the region of an implanted region 9' are described with reference to Figures 3A-3C according to one embodiment of the present invention and, in particular, with reference to the manufacturing of an MPS device 1 of Figure 1. Figures 3A-3C illustrate the manufacturing of a single implanted region 9'; however, the teaching is extensible to the concurrent manufacturing of any number of implanted regions 9' of a same MPS device 1. Furthermore, the teaching of Figures 3A-3C applies in a per se evident manner to the manufacturing of implanted regions (e.g., body regions) of a device of a different type, for example a transistor or a MOSFET.

With reference to Figure 3A, a wafer 100 is arranged, including the substrate 3 of SiC (in particular 4H-SiC, however other polytypes may be used such as, but not limited to, 2H-SiC, 3C-SiC and 6H-SiC).

The substrate 3 has a first conductivity type (in this embodiment an N-type dopant), and is provided with the front surface 3a and back surface 3b, that are opposite to each other along the Z-axis. The substrate 3 has a dopant concentration comprised between 1·10¹⁹ and 1·10²² atoms/cm³.

In Figure 3A, the front of the wafer 100 corresponds to the front surface 3a, and the back of the wafer 100 corresponds to the back surface 3b.

A first portion 30 of the drift layer 2, of Silicon Carbide having the first conductivity type (N) and having a dopant concentration for example comprised between 1·10¹⁴ and 5·10¹⁶ atoms/cm³ is formed on the front surface 3a of the substrate 3, for example by epitaxial growth. The portion 30 of the drift layer 2 is, in particular 4H-SiC, but other SiC polytypes, such as 2H, 6H, 3C or 15R, may be used.

The portion 30 of the drift layer 2 has a thickness defined between an upper side 30a and a lower side 30b along the Z-axis (the latter in direct contact with the front surface 3a of the substrate 3) comprised between 0.5 µm and 4 µm, for example in the range 1-2 µm, range boundaries included.

Then, on the upper side 30a of the portion 30 of the drift layer 2, a mask 31 is formed, for example by deposition of a photoresist, or TEOS, or another material adapted to the purpose. The mask 31 has a thickness between 0.5 µm and 2 µm or a thickness such as to shield the implant described hereinbelow in reference to the same Figure 3A. The mask 31 extends, in particular, in a region of the wafer 100 in which, in successive steps, the active area 4 of the MPS device 1 will be formed and in particular at the regions of the drift layer 2 comprised between the implanted regions 9' (having horizontal dimension Xn).

In top plan view, on the XY plane, the mask 31 covers regions of the upper side 30a aligned (along the Z-axis) with the surface regions that will form the Schottky cells (diodes 12) and leaves exposed regions of the upper side 30a at which it is desired to form the implanted regions 9'.

An implant step of doping species (for example, boron or aluminium), which have the second conductivity type (here, P), is then performed exploiting the mask 31 (the implant is indicated in the Figure by the arrows 33). The sub-regions 27-29 already illustrated in Figure 2 and described with reference to such Figure 2 are thus formed. The implanted region of Figure 3A extends to a maximum depth, starting from the surface 30a along the Z-axis, comprised between 0.2 and 4.0 µm.

This implant step envisages in particular the use of a channelled implant, at an energy and dose such as to reach the desired depth in the portion 30 and at the same time locally invert the electrical conductivity (from N-type to P-type) of the portion 30 subject to channelled implant, until the desired doping value of the implanted region 9' that is forming is obtained. For example, the implant step of Figure 3A comprises one or more channelled implants of doping species of the second conductivity type (e.g., Al) with implant energy comprised between 200 keV and 2000 keV and with doses between 10¹² atoms/cm² and 10¹⁵ atoms/cm², to form a lower part of the implanted region 9', with a dopant concentration comprised between 10¹⁴ and 10¹⁸.

By modulating the energies of the implant 33, the implant profile of Figure 2 may be generated, for example with reference to regions 27-29. In particular, as is known, the crystalline structure of SiC influences, during implant, the depth distribution obtained. In fact, the so-called channelling may significantly increase the penetration depth of the ions in the crystalline material with respect to an amorphous target. This phenomenon may occur if the direction of the incident ion beam is almost parallel to the main crystallographic axes or planes. In these directions, the reduction of the energy loss per ion path length is smaller and therefore the ions move deeper into the target. To theoretically describe the channelling probability, the concept of "critical channelling angle" has been introduced. In this case, the critical angle is considered as the maximum angle between the axial rows of atoms and the incoming beam for which the ions will still along that axis. To better understand and envisage channelling phenomena during ion implant, several Monte Carlo simulation software programs exist nowadays in crystalline targets, for example using the binary collision approximation (MC-BCA). Channelling is often an undesirable effect, and generally the SiC wafer is oriented in a random, non-channelling direction to minimize channelling effects during the implant. More or less Gaussian doping profiles are thus obtained with respect to depth, where the depth is determined by the energy, the ions used, and the atomic structure of the target. On the other hand, if the implant is performed along a crystallographic axis, a completely different profile will be obtained wherein the ions follow the crystal direction in depth in the target. In SiC, it has been demonstrated that the deepest channelled ions may penetrate many times the expected range of the corresponding random implant.

According to the present invention, the ion beam during implant is aligned with the channelling directions of the SiC, typically the 000-1 or 11-23 direction. Typically, the substrates are cut from ingots grown in the 000-1 direction with a surface tilted (for dicing the wafers) by 4° for wafers of 150 mm or 200 mm in diameter. This implies that to channelling implant on a 000-1 wafer, orienting the ion beam, during the implant, with a tilt of 4° is needed, and for a 11-23 wafer orienting the ion beam with a tilt of 13° or 21° is needed.

Alternatively to what has been illustrated in Figure 3A, in a further embodiment of the present invention, the sub-region 29 extends until it reaches the surface 3a of the substrate 3 or, similarly, the surface 30b of the portion 30. Therefore, in this embodiment, the implant 33 is configured in such a way as to form an implanted region in the portion 30 having an extension, along the Z-axis, equal to the corresponding extension of the portion 30.

Successively, Figure 3B, the mask 31 is removed and a further epitaxial growth step is performed to form a second portion 32 of the drift layer 2, of Silicon Carbide having the first conductivity type (N) and having a dopant concentration equal to that of the first portion 31. The portion 32 is of the same type of SiC polytype as the portion 30.

The portion 32 of the drift layer 2 has a thickness defined between an upper side 32a and a lower side 32b along the Z-axis (the latter in direct contact with the surface 30a of the first portion 30) comprised between 0.5 and 4 µm, for example in the range 1-2 µm, range boundaries included.

Then, on the upper side 32a of the portion 32, a mask 35 is formed, for example by deposition of a photoresist, or TEOS, or another material adapted to the purpose. The mask 35 has a thickness between 0.5 µm and 2 µm or in any case a thickness such as to shield the implant described herein below in reference to the same Figure 3B. The mask 35 extends, in particular, in a region of the wafer 100 wherein, in successive steps, the active area 4 of the MPS device 1 will be formed and in particular at the regions of the drift layer 2 comprised between the implanted regions 9' (having horizontal dimension Xn).

In top plan view, on the XY plane, the mask 35 covers regions of the upper side 32a aligned (along the Z-axis) with the surface regions that will form the Schottky cells (diodes 12) and leaves exposed regions of the upper side 32a at which it is desired to form the implanted regions 9'.

An implant step of doping species (for example, boron or aluminium), which have the second conductivity type (here, P), is then performed exploiting the mask 35 (the implant is indicated in the Figure by the arrows 37). The sub-regions 24-26 already illustrated in Figure 2 and described with reference to that Figure 2 are thus formed. The implanted region of Figure 3B extends for the entire thickness, along the Z-axis, of the portion 32.

This implant step envisages in particular the use of a channelled ion implant, with energy and dose such as to reach the rear surface 32b of the portion 32 and at the same time locally invert the electrical conductivity (from N-type to P-type) of the portion 32 subject to channelled implant, until the desired doping value of the implanted region 9' that is forming is obtained. For example, the implant step of Figure 3B comprises one or more channelled implants of doping species of the second conductivity type (e.g., Al) with implant energy comprised between 200 keV and 2000 keV and with doses between 10¹² atoms/cm² and 10¹⁵ atoms/cm², to form an intermediate part of the implanted region 9', with a P-type doping concentration comprised between 10¹⁴ and 10¹⁸.

By modulating the energies of the implant 37, the implant profile of Figure 2 may be generated, for example with reference to the regions 23-26. It should be noted that, to ensure electrical continuity between the sub-region 26 and the previously formed sub-region 27, the implant of Figure 3B needs to be such that the aforementioned P-type dopant concentration, comprised between 10¹⁴ and 10¹⁸, needs to be present at the interface between the region 32 and the region 30.

Successively, Figure 3C, the mask 37 is removed and a further epitaxial growth step is performed to form a second portion 38 of the drift layer 2, of Silicon Carbide having the first conductivity type (N) and having a dopant concentration equal to that of the first portion 31 or the second portion 32. The portion 38 is of the same type of SiC polytype as the portion 30 or the portion 32.

The portion 38 of the drift layer 2 has a thickness defined between an upper side 38a and a lower side 38b along the Z-axis (the latter in direct contact with the surface 30a of the first portion 30) comprised between 0.5 and 4 µm.

Then, on the upper side 38a of the portion 38, a mask 39 is formed, for example by deposition of a photoresist, or TEOS, or another material adapted to the purpose. The mask 39 has a thickness between 0.5 µm and 2 µm or in any case a thickness such as to shield the implant described hereinbelow in reference to the same Figure 3C. The mask 39 extends, in particular, in a region of the wafer 100 wherein, in successive steps, the active area 4 of the MPS device 1 will be formed and in particular at the regions of the drift layer 2 comprised between the implanted regions 9' (having horizontal dimension Xn).

In top plan view, on the XY plane, the mask 39 covers regions of the upper side 38a aligned (along the Z-axis) with the surface regions that will form the Schottky cells (diodes 12) and leaves exposed regions of the upper side 38a at which it is desired to form the implanted regions 9'.

An implant step of doping species (for example, boron or aluminium), which have the second conductivity type (here, P), is then performed, exploiting the mask 39 (the implant is indicated in the Figure by the arrows 41). The sub-regions 21-23 already illustrated in Figure 2 and described with reference to that Figure 2 are thus formed. The implanted region of Figure 3C extends for the entire thickness, along the Z-axis, of the portion 38.

This implant step envisages in particular the use of a channelled ion implant, with energy and dose such as to reach the rear surface 38b of the portion 38 and at the same time locally invert the electrical conductivity (from N-type to P-type) of the portion 38 subject to channelled implant, until the desired doping value of the implanted region 9' that is forming is obtained. For example, the implant step of Figure 3C comprises one or more channelled implants of doping species of the second conductivity type (e.g., Al) with implant energy comprised between 200 keV and 2000 keV and with doses between 10¹² atoms/cm² and 10¹⁵ atoms/cm², to form an upper part of the implanted region 9', with a P-type dopant concentration comprised between 10¹⁴ and 10¹⁸.

By modulating the energies of the implant 41, the implant profile of Figure 2 may be generated, for example with reference to the regions 21-23. It should be noted that, to ensure electrical continuity between the sub-region 23 and the previously formed sub-region 24, the implant of Figure 3C needs to be such that the aforementioned P-type dopant concentration, comprised between 10¹⁴ and 10¹⁸, needs to be present at the interface between the region 38 and the region 32.

The mask 39 can then be removed.

The implanted regions 9' of Figure 1 are thus formed. The implant 41 of Figure 3C may be used to form, concurrently, the edge termination 10, when present. Alternatively, the edge termination 10 is formed by a dedicated implant.

In case the process described here is aimed at forming body regions of a transistor, for example a MOSFET transistor, it is possible to proceed with further manufacturing steps for example illustrated in Figure 3D. In this case, a further epitaxial growth is performed to form a portion 44 of SiC with N-type doping. An N-type doping species channelled implant is performed to form an implanted region that reaches the entire thickness of the portion 44, so as to ensure electrical continuity with the underlying doped sub-region 23. Further (non-channelled) implants may then be performed to complete the formation of the electrical terminal being manufactured (e.g., a source N implant within the body well P).

To complete the step of Figure 3C and (for the respective embodiment) of Figure 3D, for example, a step of thermal processing (or thermal annealing) is performed to favour the activation of the implanted doping species. Annealing is, for example, performed at a temperature higher than 1600°C (e.g., between 1700°C and 1900°C and in some cases even higher).

Further formation steps of ohmic contacts 9" and 6 and/or the anode 11 and cathode 7 metallizations (described with reference to Figure 1) are performed in a manner known per se.

For example, with joint reference to Figures 1 and 3C, the ohmic contacts 9" (e.g., of nickel silicide) are formed at each implanted region 9', thereby contributing to the formation of respective JB elements 9. Forming the ohmic contacts 9" includes forming a hard mask of a thin oxide (e.g., in the range 100 nm to 500 nm); successively, photolithography and etching steps are performed to etch the regions where the ohmic contacts 9" are to be formed; successively, a deposition of metal material (e.g. Nickel) is performed and a successive annealing is performed (e.g., at a temperature in the range 900°C to 1100°C for a time interval in the range 1 minute to 120 minutes). The metal thus deposited reacts with the surface SiC material forming an ohmic compound (e.g. Nickel Silicide), while the metal in contact with the oxide of the hard mask does not react. Successively, a removal step of the unreacted metal and the hard mask is performed. Successively, a formation step of an anode terminal is performed. For this purpose, an interface layer of metal material, such as e.g. Titanium, or Nickel, or Molybdenum, is deposited on the drift layer 2. The interface layer is deposited by sputtering and has a thickness approximately between 10 nm and 500 nm. The interface layer extends in contact with the implanted regions 9' through the ohmic contacts 9" and with the exposed regions of the drift layer 2 (i.e., the Schottky cells). In particular, the interface layer contributes to the formation of a Schottky/Schottky barrier contact with the exposed regions of the drift layer 2 and to the formation of the junction barrier (JB) elements with the implanted regions 9' through the ohmic contacts 9". Successively, a further metal layer 68 is formed on the upper part of, and in direct contact with, the interface layer. The metal layer, for example, is of aluminium or copper and has a thickness of a few microns, for example between 1 and 10 µm. The ensemble formed by the interface layer and the metal layer forms the anode metallization 11 already discussed in reference to Figure 1. A plurality of semiconductor-metal junctions of the Schottky type (Schottky diodes 12) are similarly formed between the anode metallization 11 and the regions of the drift layer 2 which have the first conductivity type (N), as indicated in Figure 1. In an alternative embodiment (not illustrated), the interface layer is omitted, in such a way that the metal layer extends in direct contact with the drift layer 2.

Then, a cathode terminal 7 is formed on the back of the wafer 100, i.e. at the back surface 3b of the substrate 3, in a manner similar to what has been described for the formation of the anode terminal 11.

Multiple MPS devices 1 or multiple transistors, or both, may be formed on the same wafer 100. In this case, a final singulation step of the wafer 100 is performed to physically insulate dice comprising respective MPS devices 1 and/or transistors, as needed.

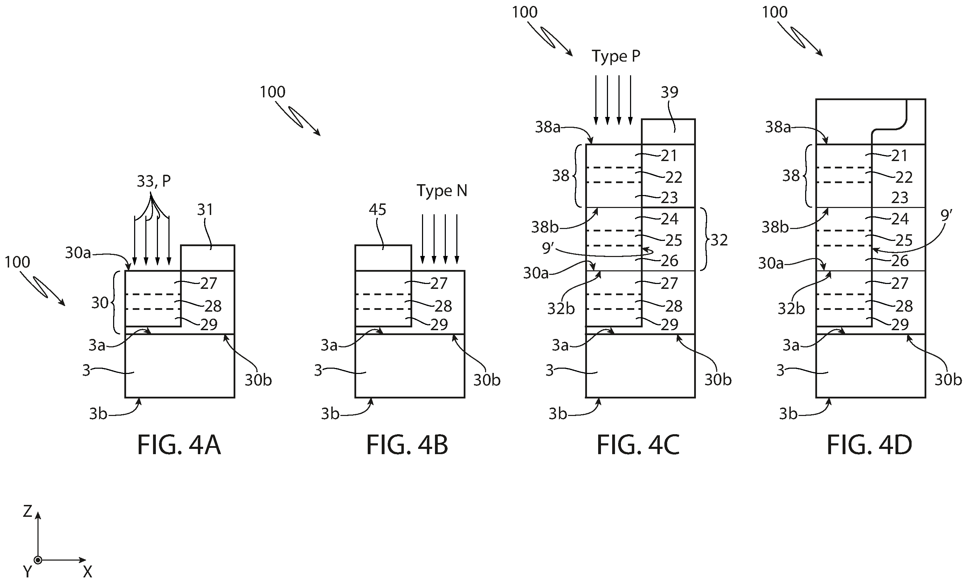

Figures 4A-4D illustrate an alternative embodiment to that of Figures 3A-3D.

Elements or manufacturing steps common to those of Figures 3A-3D are identified with the same reference numbers and are not further described.

With reference to Figure 4A, the same steps as in Figure 3A are performed.

With reference to Figure 4B, a step of masked implant of doping species, having the first electrical conductivity (N), is performed laterally to the implanted sub-regions 27-29, i.e. in the part of the portion 30 having the first electrical conductivity (N). For this purpose, an implant mask 45 is formed above, and aligned along the Z-axis with, the implanted sub-regions 27-29. An implant, in particular of the channelled type, of doping species having the first electrical conductivity (e.g., phosphorus), is then performed, in such a way as to increase the charge density in the portion 30 laterally to the sub-regions 27-29, for example until reaching a charge density comprised between 10¹⁴ atoms/cm³ and 10¹⁸ atoms/cm³.

Then, Figure 4C, the method proceeds in a manner similar to what has been described with reference to Figure 3C, forming a further portion 32 grown epitaxially and implanting doping species having the second electrical conductivity (P) aligned, along Z, with the previously formed sub-regions 27-29. After this step, differently from what has been described for Figure 3C, an implant step of doping species having the first electrical conductivity (N) is performed in the portion 32 laterally to the sub-regions 24-26, so as to increase the dose of doping agents having the first electrical conductivity (N) laterally to the sub-regions 24-26, similarly to what has been described for Figure 4B. The method then proceeds with the formation of the portion 38 grown epitaxially and, therefore, with the implant step of doping species having the second electrical conductivity (P) in the portion 38, to form the sub-regions 21-23. A further implant step of doping species having the first electrical conductivity (N) is then performed in the portion 38 laterally to the sub-regions 21-23, similarly to what has been described for Figure 4B.

Figure 4D illustrates part of a transistor, in particular a MOSFET transistor, of the type already described with reference to Figure 3D, in which the epitaxial layer formed by the portions 30, 32, 38 (and possibly further epitaxial portions) has a higher doping than what has been described for Figures 3A-3D. In Figure 4D, similarly to Figure 3D, the body well is formed in part according to the process of Figures 4A-4C.

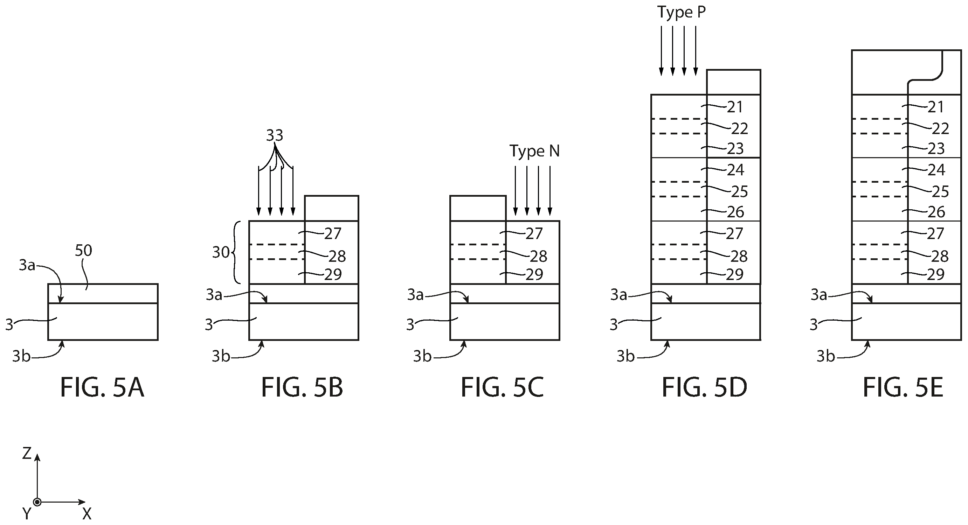

Figures 5A-5E illustrate a process according to a further embodiment of the present invention. Elements and steps common to those of Figures 3A-3D and 4A-4D are illustrated with the same reference numbers and are not further described.

With reference to Figure 5A, after having arranged the substrate 3, an epitaxial growth step is performed to form a portion 50, of SiC, on the surface 3a of the substrate 3. The portion 50 has a thickness for example comprised between 0.5 and 2 µm. The portion 50 has a doping comprised between 10¹⁴ atoms/cm³ and 10¹⁷ atoms/cm³.

Then, Figure 5B, an epitaxial growth step is performed to form the portion 30, that extends above the portion 50. In other words, in this embodiment, the portion 50 is between the substrate 3 and the portion 30 previously described.

An implant 33, in particular a channelled implant, is then performed to form the implanted sub-regions 27-29. In the illustrated example, the region 29 extends to the interface between the portion 30 and the underlying portion 50, so that the implanted sub-regions 27-29 have, as a whole, a thickness equal to the thickness of the portion 30. However, it is evident that this implementation is not limiting and the implanted sub-regions 27-29 may alternatively have, as a whole, a thickness lower than the thickness of the portion 30, or greater than the thickness of the portion 30 (with the sub-region 29 that extends within the portion 50).

Then, Figures 5C and 5D, the steps already described with reference to Figures 4B and 4C, respectively, are performed. Figure 5E illustrates, similarly to Figures 3D and 4D, a portion of a transistor, for example a MOSFET transistor, in which the body well is formed in part according to the process of Figures 5A-5D.

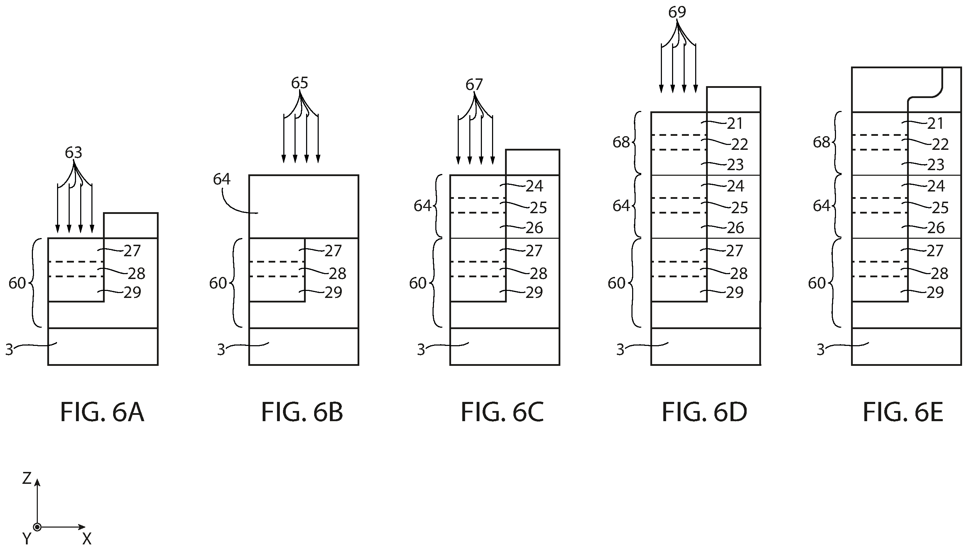

Figures 6A-6E illustrate a process according to a further embodiment of the present invention. Elements and steps common to those of Figures 3A-3D, 4A-4D and 5A-5E, are illustrated with the same reference numbers and are not further described.

With reference to Figure 6A, after having arranged the substrate 3, an epitaxial growth step of the portion 30 of Figure 3A is performed, having the first conductivity (N); then, a step of non-masked implant, for example of the channelled type, of doping species having the first conductivity (N) is performed, to increase the dopant concentration in the portion 30, thus obtaining a portion 60 having the first conductivity (N) and dopant concentration in the range 10¹⁴ atoms/cm³ and 10¹⁷ atoms/cm³.

Again with reference to Figure 6A, a formation step of the implanted sub-regions 27-29 is performed, for example by a channelled implant, and identified by the arrows 63. The implant 63 is similar to the implant 33 described with reference to Figure 3A, but since the portion 60 has a higher doping density, the dose of doping species implanted with the implant 63 also needs to be higher than with the implant 33, in order to obtain the local charge inversion and the expected doping concentration for the sub-regions 27-29.

The method then proceeds, Figure 6B, with an epitaxial growth step to form a portion 64 of the drift layer 2, superimposed on the region 60. For example, after having grown epitaxially the region 32 on the region 60, an implant step 65, for example a channelled implant, of doping species having the first conductivity (e.g., phosphorus) is performed, to increase the doping of the region 32 and obtain a doping in the range 10¹⁴ atoms/cm³ and 10¹⁷ atoms/cm³. The region 64 is thus formed.

Then, Figure 6C, an implant 67 of doping species having the second electrical conductivity (P) is performed, to form the sub-regions 24-26, as already described with reference to Figure 3B. Even in this case, since the portion 64 has a higher doping density than the portion 32, the dose of doping species implanted with the implant 67 needs to be higher than the implant 37 of Figure 3B, in order to obtain the local charge inversion and the expected doping concentration for the sub-regions 24-26.

The method then proceeds, Figure 6D, with the formation of a further portion 68, grown epitaxially in a manner similar to portion 38 of Figure 3C. An implant (not illustrated) allows to increase the doping of the portion 68, and obtain a doping in the range 10¹⁴ atoms/cm³ and 10¹⁷ atoms/cm³. Portion 68 has the first electrical conductivity type (N).

An implant 69 of doping species having the second electrical conductivity (P) is then performed, to form the sub-regions 21-23, as already described with reference to Figure 3C. Even in this case, since the portion 68 has a higher doping density than the portion 38, the dose of doping species implanted with the implant 69 needs to be higher than with implant 41 of Figure 3C, in order to obtain the local charge inversion and doping concentration expected for the sub-regions 21-23.

Figure 6E illustrates, similarly to Figures 3D, 4D and 5E, a portion of a transistor, e.g. a MOSFET transistor, in which the body well is formed in part according to the process of Figures 6A-6D.

Finally, it is clear that modifications and variations may be made to what has been described and illustrated herein, without thereby departing from the scope of the present invention, as defined in the appended claims.

In particular, the epitaxial growth steps of Figures 3A-3C (similarly, of Figures 4A-4C, 5A-5D, 6A-6D) are not limited to three, as illustrated and described, but may be in any number.

Furthermore, as already previously observed, the present invention is not limited to the formation of an MPS device, but extends to the manufacturing of a generic electronic device, such as for example Schottky diodes, JBS diodes, MOSFETs, IGBTs, JFETs, DMOS, vertical conduction transistors, etc.

## Claims

1. An electronic device (1), comprising:
- a substrate (3) of silicon carbide, SiC, having a first electrical conductivity (N), and having a first surface (3a) and a second surface (3b) opposite to each other along a direction (Z);
- a structural layer (2) of SiC having the first electrical conductivity (N), extending on the first surface (3a) of the substrate (3), and having a first surface (2a) and a second surface (2b) opposite to each other along said direction (Z), the first surface (3a) of the substrate (3) directly facing the second surface (2b) of the structural layer (2) and wherein a thickness of the structural layer is the distance of the first surface (2a) from the second surface (2b) along said direction (Z);
- at least one active region (9') extending in the structural layer (2) along said direction (Z) starting from the first surface (2a), said active region being configured to generate and/or conduct electric current during use of the electronic device (1), wherein the active region (9') is a doped region having a second electrical conductivity (P) opposite to the first electrical conductivity (N) and extends in the structural layer (2), along said direction (Z) starting from the first surface (2a) of the structural layer (2), for an extension greater than half the thickness of the structural layer (2).

2. The electronic device according to claim 1, wherein the active region (9') comprises first (21, 24, 27), second (22, 25, 28) and third (23, 26, 29) sub-regions that alternate cyclically with each other along said direction (Z).

3. The electronic device according to claim 1 or claim 2, wherein:
the first sub-region has a monotonically increasing doping profile along said direction (Z);
the second sub-region has a substantially uniform doping profile and is located successively to the first sub-region along said direction (Z); and
the third sub-region has a monotonically decreasing doping profile and is located successively to the second sub-region along said direction (Z).

4. The electronic device according to claim 3, wherein the first sub-region has a doping density increasing from a minimum value (D0) between 1·10¹³ and 1·10^{1⁸} at/cm³ to a maximum value (D1) between 1·10^{1⁷} and 1·10^{1⁹} at/cm³, the second sub-region has a doping density (D2) between 2·10^{1⁷} and 1·10^{2⁰} at/cm³, and the third sub-region has a doping density decreasing from a maximum value (D3) between 1·10^{1⁷} and 1·10^{1⁹} at/cm³ to a minimum value (D4) between 1·10¹³ and 1·10^{1⁸} at/cm³.

5. The electronic device according to anyone of the preceding claims, said electronic device being a transistor further comprising a body region, having the second electrical conductivity (P), facing the first surface (2a) of the structural layer (2), wherein the active region (9') extends with electrical continuity of the body region.

6. The electronic device according to anyone of the preceding claims, wherein the first and third sub-regions have a respective concentration of doping species having a value lower than the value of the concentration of doping species of the second sub-region.

7. The electronic device according to anyone of the preceding claims, wherein each second sub-region is comprised, along said direction (Z), between a respective first sub-region and a respective third sub-region.

8. The electronic device according to anyone of the preceding claims, wherein said electronic device is a Merged-PN-Schottky, MPS, diode wherein the structural layer (2) is a drift layer of the MPS diode,
further comprising:
a first conductive terminal (8), forming an anode terminal of the MPS diode, in electrical contact with the active region (9') and with the structural layer (2) laterally to the active region (9'), so as to form a junction barrier, JB, diode with said active region (9') and a Schottky diode with the structural layer (2); and
a second electrical terminal (7) at the substrate (3), being a cathode terminal of the MPS diode.

9. A method of manufacturing an electronic device (1), comprising the steps of:
- arranging a substrate (3) of silicon carbide, SiC, having a first electrical conductivity (N), and having a first surface (3a) and a second surface (3b) opposite to each other along a direction (Z);
- forming a structural layer (2) of SiC, having the first electrical conductivity (N), on the first surface (3a) of the substrate (3), the structural layer having a first surface (2a) and a second surface (2b) opposite to each other along said direction (Z), the first surface (3a) of the substrate (3) directly facing the second surface (2b) of the structural layer (2) and wherein a thickness of the structural layer is the distance of the first surface (2a) from the second surface (2b) along said direction (Z);
- forming at least one active region (9') in the structural layer (2) along said direction (Z) starting from the first surface (2a), said active region being configured to generate and/or conduct electric current during use of the electronic device (1), wherein the step of forming the active region (9') comprises forming, in the structural layer (2) along said direction (Z), a doped region having a second electrical conductivity (P) opposite to the first electrical conductivity (N) for an extension greater than half the thickness of the structural layer (2).

10. The method according to claim 9, wherein the step of forming the active region (9') comprises forming first (21, 24, 27), second (22, 25, 28) and third (23, 26, 29) sub-regions that alternate cyclically with each other along said direction (Z).

11. The method according to claim 10, wherein the step of forming the active region (9') comprises forming:
the first sub-region with a monotonically increasing doping profile along said direction (Z);
the second sub-region with a substantially uniform doping profile, successively to the first sub-region; and
the third sub-region with a monotonically decreasing doping profile, successively to the second sub-region.

12. The method according to anyone of claims 9-11, wherein the step of forming the active region (9') comprises:
forming a first portion (30) of the structural layer (2) on the first surface (3a) of the substrate (3);
performing a first channelled implant (33) of doping species having the second electrical conductivity (P) at a first selective region of the first portion (30);
forming a second portion (32) of the structural layer (2) on the first portion (30); and
performing a second channelled implant (37) of doping species having the second electrical conductivity (P) at a second selective region of the second portion (32), wherein said second selective region is at least in part aligned with the first selective region along said direction (Z).

13. The method according to claim 12, wherein the second channelled implant (37) is configured to implant doping species until it reaches an interface between the first portion (30) and the second portion (32) of the structural layer (2).

14. The method according to claim 12 or 13, wherein the first and second portions (30, 32) of the structural layer (2) have a respective thickness comprised between 0.5 µm and 4 µm.

15. The method according to anyone of claims 12-14, further comprising the step of forming a third portion (50) of the structural layer (2) between the substrate (3) and the first portion (30) of the structural layer (2), the third portion (50) having the first electrical conductivity (N); and wherein the first channelled implant (33) is configured to implant doping species at a distance from the third portion (50) of the structural layer (2).
